Europäisches Patentamt

European Patent Office

Office européen des brevets

(19)

(11) Numéro de publication : **0 187 091**
**B1**

(12) **FASCICULE DE BREVET EUROPÉEN**

(45) Date de publication du fascicule du brevet :
26.04.89

(21) Numéro de dépôt : 85402477.5

(22) Date de dépôt : 12.12.85

(51) Int. Cl.⁴ : **G 01 R 15/07, G 02 F 1/01**

(54) **Système analyseur de transitoires.**

(30) Priorité : 18.12.84 FR 8419361

(43) Date de publication de la demande :
09.07.86 Bulletin 86/28

(45) Mention de la délivrance du brevet :
26.04.89 Bulletin 89/17

(84) Etats contractants désignés :
CH DE GB IT LI

(56) Documents cités :
DE—A— 3 127 406
FR—A— 2 508 754
1980 IEEE MTT-S INTERNATIONAL MICROWAVE
SYMPOSIUM DIGEST, catalogue no. 77-645125, 1980,
pages 317-318, IEEE, New York, US; H.I. BASSEN et
al.: "An RF field strength measurement system using
an integrated optical linear modulator
IBM TECHNICAL DISCLOSURE BULLETIN, vol. 26,
no. 12, mai 1984, pages 6604-6605, New York, US; J.A.
KASH: "Picosecond streak camera with single pho-
ton sensitivity"
ADVANCES IN INSTRUMENTATION, vol. 37, partie 3,
1982, pages 1655-1671, ISA, Research Triangle Park,
US; A.R. TEBO: "Sensing with optical fibers: an
emerging technology"

(73) Titulaire : THOMSON-CSF
173, Boulevard Haussmann
F-75379 Paris Cédex 08 (FR)

(72) Inventeur : d'Humieres, Etienne
THOMSON-CSF SCPI 173, bld. Haussmann
F-75379 Paris Cedex 08 (FR)
Inventeur : Bernet, Jean-Marie
THOMSON-CSF SCPI 173, bld. Haussmann
F-75379 Paris Cedex 08 (FR)
Inventeur : Eumurian, Grégoire
THOMSON-CSF SCPI 173, bld. Haussmann
F-75379 Paris Cedex 08 (FR)

(74) Mandataire : Trocellier, Roger et al
THOMSON-CSF SCPI
F-92045 PARIS LA DEFENSE CEDEX 67 (FR)

Jouve, 18, rue St-Denis, 75001 Paris, France

EP 0 187 091 B1

## Description

La présente invention concerne un système analyseur de transitoires rapides, les signaux à analyser pouvant avoir une durée comprise, par exemple, entre 30 picosecondes et quelques nanosecondes.

Pour l'analyse de signaux très rapides, il est connu d'utiliser comme dispositif analyseur une caméra à balayage de fente associée à une caméra de télévision en circuit solide. La caméra à balayage de fente reçoit le signal à analyser sous forme optique. Si le signal est d'une autre nature, électrique par exemple, il est d'abord traité dans un circuit interface d'entrée qui le transforme en signal optique calibré. Les différents signaux optiques à traiter sont transmis par l'intermédiaire d'une optique à fibres à la caméra à balayage de fente, dite streak caméra en terminologie anglo-saxonne. Cette optique intermédiaire peut être constituée par des fibres juxtaposées linéairement pour former la fente lumineuse sur la photocathode d'entrée. Des électrodes déflectrices sont commandées pour produire un balayage perpendiculaire à la ligne résultant des N voies optiques juxtaposées sur un écran fluorescent en sortie du tube. L'image résultante formée de N traces verticales permet ensuite, par analyse à l'aide de la caméra de télévision et d'un circuit de traitement, d'étudier la variation temporelle des signaux correspondants.

Dans la demande de brevet français n° 84 19 196 du 14/12/84 (correspondant à la demande de Brevet Européen EP-A-0 187 087 publiée le 09.07.1986) il est décrit un dispositif échantillonneur photonique dérivé des caméras à fente et aménagé de manière à traiter une voie optique d'analyse à l'entrée. Suivant cette solution, le tube comporte à l'entrée une photocathode de dimensions réduites et est associé directement à un dispositif détecteur d'image en circuit solide constitué par une simple barrette détectrice orientée suivant la trace lumineuse à détecter. L'ensemble est réalisable de manière plus compacte et présente de multiples avantages, notamment du fait que le nombre d'échantillons correspondant au nombre d'éléments de la barrette détectrice est plus élevé que celui fourni par une matrice en circuit solide.

Le but de l'invention est de réaliser un système analyseur de transitoires tel que décrit par exemple dans le document FR-A-2 508 754 pour lequel le signal à analyser peut être électrique ou, s'il n'est pas électrique ni optique, est transformé préliminairement en signal électrique avant d'être fourni à l'analyseur sous forme optique, lequel dispositif d'analyse étant avantageusement du type précité répondant à l'analyse d'une voie unique.

Suivant l'invention il est proposé de réaliser le système analyseur tel que définit à la revendication 1. Dans le cas où le signal à analyser n'est ni électrique ni optique, le dispositif adaptateur comporte des moyens complémentaires pour transformer ce signal à analyser en signal électrique de modulation.

Les particularités et avantages de la présente invention apparaîtront dans la description qui suit donnée à titre d'exemple, à l'aide des figures annexées qui représentent :

— Fig. 1, un diagramme général d'un système d'analyse de transitoires conforme à l'invention ;

— Fig. 2, un schéma d'un interféromètre à deux bras de type connu, utilisable comme modulateur d'intensité lumineuse dans le système selon la figure 1 ;

— Fig. 3, la courbe de réponse de l'interféromètre selon la figure 2 ;

— Fig. 4, un mode de réalisation du circuit modulateur d'intensité lumineuse sous forme d'un capteur de champ magnétique ;

— Fig. 5, un deuxième mode de réalisation du circuit modulateur d'intensité lumineuse sous forme d'un capteur de champ électrique ;

— Fig. 6, un troisième mode de réalisation du circuit modulateur d'intensité lumineuse sous forme d'un capteur de pression ;

— Fig. 7, une représentation partielle d'un mode de réalisation du système d'analyse de transitoires selon la figure 1 utilisant un interféromètre selon la figure 2 et un tube échantillonneur photonique comme analyseur de transitoires optiques.

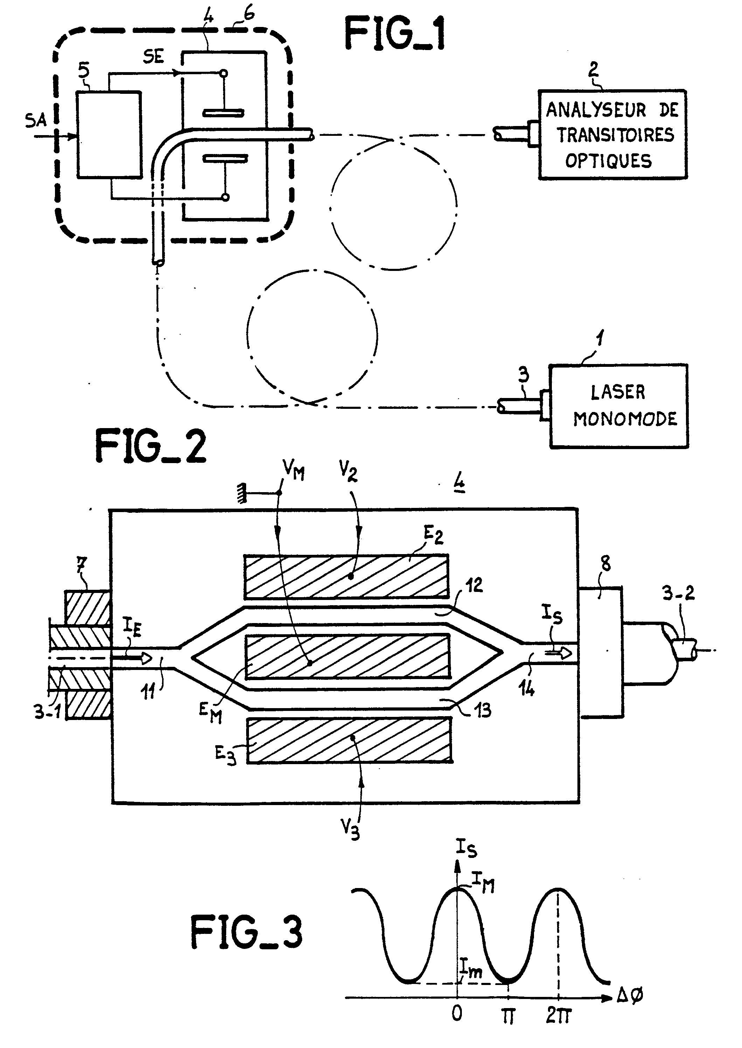

En se reportant à la figure 1 le système analyseur de transitoires comporte un laser monomode 1 relié par une fibre monomode 3 à l'entrée d'un dispositif analyseur de transitoires optiques 2. La source cohérente, émet de manière continue et le signal à analyser SA est utilisé dans un circuit intermédiaire 6 pour moduler l'intensité lumineuse dans la fibre 3. Ce circuit intermédiaire 6 constitue un circuit d'interface ou un dispositif adaptateur ; il comporte essentiellement un circuit modulateur d'amplitude 4 réalisé en optique intégrée et qui permet de moduler l'intensité lumineuse du signal optique en fonction des variations présentées par un signal électrique d'entrée SE appliqué au circuit 4. Si le signal à analyser SA est sous forme électrique, il est appliqué directement au circuit 4 ; si par contre il n'est pas électrique, ni évidemment non plus optique ce qui est exclu dans la configuration présentée, il est appliqué préalablement à un circuit complémentaire 5 qui le traduit sous forme électrique SE utilisable par le circuit modulateur d'intensité lumineuse 4.

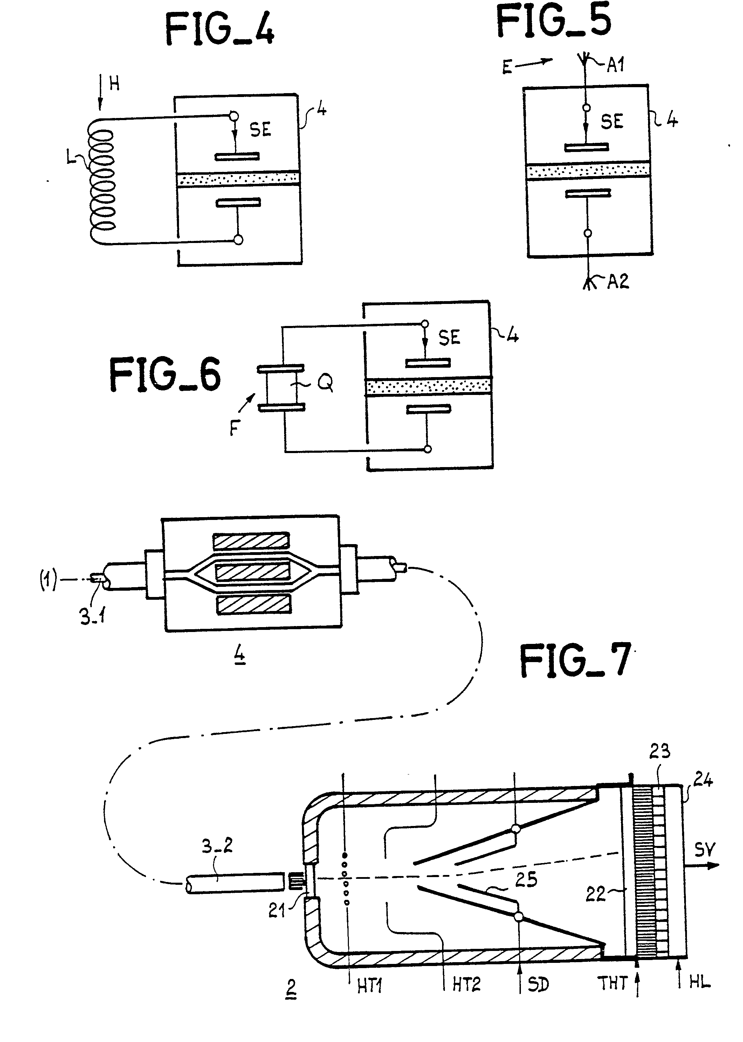

Le circuit modulateur d'intensité lumineuse pourra être constitué de manière connue par un interféromètre à deux bras dont la structure est rappelée sur la figure 2. On note que la fibre monomode 3 est constituée en fait de trois éléments, un élément 3.1 qui relie l'interféromètre à la source laser 1 et un élément 3.2 qui relie cet interféromètre ensuite à l'analyseur 2. Le circuit 6 comporte des dispositifs coupleurs optiques 7 et 8 pour coupler convenablement les extrémités des fibres monomodes 3.1 et 3.2 respectivement à l'entrée et à la sortie de l'interféromètre à deux bras. Cet interféromètre comporte une branche 11 de guide d'onde monomode dans laquelle circule une onde lumineuse d'intensité $I_E$ ; cette branche 11 se divise en deux bras parallèles 12 et 13 qui se rejoignent ensuite pour former une branche 14 de sortie où l'on peut récupérer une intensité IS. Les directions de propagation de la lumière sont les mêmes dans les quatre guides. Des électrodes sont disposées entre les guides 12 et 13, électrode $E_M$, et de part et d'autre de ces deux guides, électrodes $E_2$ et $E_3$. L'électrode $E_M$ est raccordé au potentiel VM de masse et des tensions V2 et V3 sont appliquées aux électrodes $E_2$ et $E_3$. La disposition des électrodes adjacentes aux guides provoquent dans ceux-ci des champs électriques perpendiculaires à la direction de propagation des ondes lumineuses. L'ensemble du dispositif est réalisé à la surface d'un substrat possédant des propriétés électro-optiques. Pour des tensions V2 et V3 de même signe, les champs électriques sont de sens opposé et provoquent des variations de signe opposé dans les vitesses de propagation des ondes lumineuses dans les deux bras. La différence entre les vitesses de propagation est proportionnelle à la somme des amplitudes des champs électriques appliqués, c'est-à-dire sensiblement proportionnelle à la somme des tensions V2 et V3. On obtient à la sortie un déphasage entre les deux ondes qui se trouvaient primitivement en phase. L'intensité IS récupérée varie en fonction du déphasage selon une loi sinusoïdale représentée sur la figure 3 dont l'intensité varie entre un minimum Im et un maximum IM, le taux de modulation IM/Im étant fonction des pertes de couplage et de la dissymétrie du dispositif. Dans l'application considérée le signal SE est superposé à l'une des tensions V2 ou V3 qui sont originellement à un même potentiel V. Pour un signal SE analogique, l'intensité IS suit la modulation à condition que le déphasage reste compris entre $2n\pi$ et entre $(2n+1)\pi$ de façon à conserver une pente de courbe constante. A noter que cette réponse sinusoïdale peut être linéarisée en ajoutant une boucle de rétroaction optoélectronique selon la technique décrite dans la publication de brevet français FR-A-2 453 426.

Les figures 4 à 6 se rapportent à des exemples d'utilisation du système dans divers cas où le signal à analyser SA n'est pas de nature électrique.

Dans l'exemple de la figure 4 le signal à analyser est un champ magnétique H et le circuit 5 d'entrée est constitué par une bobine L dans laquelle le champ H induit un courant qui se traduit par un signal électrique SE utilisable par le circuit modulateur 4.

Dans le cas de la figure 5, le signal à analyser est un champ électrique et le circuit d'entrée 5 est formé par des antennes A1 et A2.

Dans le cas de la figure 6 le signal à analyser est une force F et le circuit 5 de la figure 1 est constitué à l'aide d'un quartz Q.

On remarque que les montages proposés selon les figures 4 à 6, ainsi que d'autres montages possibles pour d'autres natures de signal à analyser, permettent de constituer un dispositif capteur de mesure 6 aisément déplaçable du fait qu'il est relié au circuit annexe 1 et 2 par l'intermédiaire d'une fibre optique, que ce capteur est isolé électriquement, qu'il est miniaturisé et qu'il est passif étant donné qu'il ne nécessite aucune alimentation.

Dans la représentation figure 7 on a représenté partiellement une réalisation préférée du système de la figure 1 en utilisant un interféromètre à deux bras 4 pour moduler l'intensité lumineuse dans la fibre monomode 3 et dans lequel l'analyseur de transitoires optiques 2 est constitué par un dispositif échantillonneur photonique dérivé des tubes caméras à fente et particularisé en ce qu'il comporte à l'entrée une photocathode 21 de faibles dimensions et en ce que son écran fluorescent 22 est couplé directement à une barrette détectrice 23 en circuit solide. On distingue à l'intérieur du tube des électrodes de concentration et de focalisation qui reçoivent des hautes tensions HT1, HT2, une électrode d'anode alimentée par une très haute tension THT et des électrodes de déflexion 25 recevant des signaux de déflexion SD pour produire le balayage selon la direction de la barrette. La barrette 23 est associée à des circuits d'amplification et de lecture 24 qui fournissent le signal vidéo détecté SV. La lecture est synchronisée par un signal d'horloge locale HL.

## Revendications

1. Système analyseur de transitoires rapides d'un signal non lumineux, comportant des moyens pour transformer le signal à analyser en une information lumineuse, ces moyens consistant en une source laser monomode (1) à émission continue, un dispositif adaptateur et modulateur (6) ayant une entrée de réception du signal à analyser, une entrée optique et une sortie optique, un conducteur de lumière en fibre optique monomode (3) en deux éléments (3.1, 3.2) pour coupler optiquement à l'aide d'un premier élément (3.1) ladite source à l'entrée optique et par le deuxième élément (3.2) ladite sortie optique à un dispositif analyseur (2), le dispositif adaptateur et modulateur comprenant un circuit (5) pour transformer le signal à analyser en un signal électrique de modulation, et un modulateur d'amplitude (4) pour moduler l'intensité lumineuse du signal laser continu en fonction des variations du signal de modulation, caractérisé en ce que le dispositif analyseur (2) est un analyseur de transitoires optiques du type caméra à balayage de fente comportant un tube échantillonneur photonique dont la photocathode d'entrée (21) est couplée audit deuxième élément de fibre (3-2) et dont l'écran fluorescent est couplé à un dispositif détecteur (23) en circuit solide à transfert de charges.

2. Système selon la revendication 1 caractérisé en ce que la photocathode (21) est de dimensions réduites et le dispositif détecteur (23) est constitué par une unique barrette dont la direction correspond à celle de déflexion du faisceau cathodique.

3. Système selon la revendication 1 ou 2, caractérisé en ce que le signal à analyser (SA) est disponible sous forme électrique et constitue directement ledit signal de modulation, l'ensemble permettant d'analyser des transitoires électriques.

4. Système selon la revendication 1 ou 2, et dans lequel le dispositif adaptateur constitue un capteur aisément déplaçable et passif, caractérisé en ce que le circuit modulateur d'amplitude (4) est réalisé par un circuit interférométrique à deux bras en optique intégrée, ledit système permettant d'analyser des transitoires pouvant atteindre jusqu'à 30 picosecondes environ.

5. Système selon la revendication 4, caractérisé en ce que le signal à analyser est un champ magnétique (H) et en ce que le circuit de transformation (5) est formé par une bobine (L).

6. Système selon la revendication 4, caractérisé en ce que le signal à analyser est un champ électrique (E) et en ce que le circuit de transformation est formé par une antenne (A1, A2).

7. Système selon la revendication 4, caractérisé en ce que le signal à analyser et une force (F) et que le circuit de transformation (5) est formé par un quartz (Q).

## Claims

1. A system for analyzing rapid transients of a signal which is not a light signal, comprising means for transforming the signal to be analyzed into a light information, these means consisting in a continuously transmitting monomode laser source (1), a matching and modulating device (6) having an input for receiving the signal to be analyzed, an optical input and an optical output, a light conductor of the optical monomode fibre type (3) made of two elements (3-1, 3-2) intended to optically couple said source by means of the first one of said elements (3-1) to the optical input and to couple the optical output by means of the second element (3-2) to an analyser device (2), the matching and modulating device comprising a circuit (5) for transforming the signal to be analyzed into an electric modulation signal and an amplitude modulator (4) intended to modulate the light intensity of the continuous laser signal in accordance with the variations of the modulation signal, characterized in that the analyser device (2) is an optical transient analyser of the slot scanning camera type and comprises a photonic sampling tube, the input photocathode (21) of which is coupled to said second fibre element (3-2) and the fluorescent screen of which is coupled to a solid state detector device (23) of the charge transfer type.

2. A system according to claim 1, characterized in that the photocathode (21) has a reduced size and the detector device (23) is constituted by a unique bar, the direction of which corresponds to that of the deflection of the cathode beam.

3. A system according to claim 1 or 2, characterized in that the signal to be analyzed (SA) is available in electric form and constitutes directly said modulation signal, the system being conceived to analyze electric transients.

4. A system according to claim 1 or 2, in which the matching device constitutes a readily displacable and passive probe, characterized in that the amplitude modulator circuit (4) is constituted by an interferometric circuit with two arms of the optical integration type, said system allowing the analysis of transients which can range down to about 30 ps.

5. A system according to claim 4, characterized in that the signal to be analysed is a magnetic field (H) and that the transformation circuit (5) is constituted by a coil (L).

6. A system according to claim 4, characterized in that the signal to be analyzed is an electric field (E) and that the transformation circuit is constituted by an antenna (A1, A2).

7. A system according to claim 4, characterized in that the signal to be analyzed is a force (F) and that the transformation circuit (5) is constituted by a quartz (Q).

## Patentansprüche

1. System zur Analyse rascher Übergänge eines Signals, das kein Lichtsignal ist, mit Mitteln zur Umwandlung des zu analysierenden Signals in eine Lichtinformation, die aus einer kontinuierlich aussendenden Monomode-Laserquelle (1) besteht, mit einer Anpaß- und Modulationsvorrichtung (6), die einen Eingang zum Empfang des zu analysierenden Signals, einem optischen Eingang und einen optischen Ausgang besitzt, mit einem aus zwei Elementen (3-1, 3-2) einer Monomode-Lichtleitfaser gebildeten Lichtleiter, um mit Hilfe eines ersten der Elemente (3-1) die Quelle an den optischen Eingang und mit Hilfe des zweiten Elements (3-2) den optischen Ausgang an eine Analysiervorrichtung (2) optisch zu koppeln, wobei die Anpaß- und Modulationsvorrichtung einen Kreis (5) zur Umwandlung des zu analysierenden Signals in ein elektrisches Modulationssignal und einen Amplitudenmodulator (4) aufweist, um die Lichtintensität des kontinuierlichen Lasersignals abhängig von den Änderungen des Modulationssignals zu modulieren, dadurch gekennzeichnet, daß die Analysiervorrichtung (2) ein optischer Transientenanalysator von der Art einer Kamera mit Schlitzabtastung ist, die eine Photonentaströhre enthält, deren Eingangsphotokathode (21) an das zweite Lichtleitfaserelement (3-2) gekoppelt ist und dessen Leuchtschirm mit einer Festkörper-Detektorvorrichtung (23) vom Ladungstransfertyp verbunden ist.

2. System nach Anspruch 1, dadurch gekennzeichnet, daß die Photokathode (21) reduzierte Abmessungen besitzt und die Detektorvorrichtung (23) aus einer einzigen Leiste besteht, deren Richtung der der Ablenkung des Kathodenstrahls entspricht.

3. System nach Anspruch 1 oder 2, dadurch gekennzeichnet, daß das zu analysierende Signal (SA) in elektrischer Form vorliegt und unmittelbar das Modulationssignal bildet, derart, daß das System die Analyse der elektrischen Transienten ermöglicht.

4. System nach Anspruch 1 oder 2, in dem die Anpaßvorrichtung eine leicht verschiebbare passive Sonde bildet, dadurch gekennzeichnet, daß der Amplitudenmodulatorkreis (4) als Interferometerkreis mit zwei Armen in integrierter Optik ausgebildet ist, derart, daß das System die Analyse der Transienten bis hinunter zu etwa 30 Picosekunden erlaubt.

5. System nach Anspruch 4, dadurch gekennzeichnet, daß das zu analysierende Signal ein Magnetfeld (H) ist und daß der Umwandlungskreis (5) von einer Spule (L) gebildet wird.

6. System nach Anspruch 4, dadurch gekennzeichnet, daß das zu analysierende Signal ein elektrisches Feld (E) ist und daß der Umwandlungskreis von einer Antenne (A1, A2) gebildet wird.

7. System nach Anspruch 4, dadurch gekennzeichnet, daß das zu analysierende Signal eine Kraft (F) ist und daß der Umwandlungskreis (5) von einem Quarz (Q) gebildet wird.

EP 0 187 091 B1

# FIG_1

ANALYSEUR DE TRANSITOIRES OPTIQUES

LASER MONOMODE

# FIG_2

# FIG_3

EP 0 187 091 B1

# FIG_4

H

L

SE

4

# FIG_5

E → A1

SE

4

A2

# FIG_6

Q

F

SE

4

(1)

3_1

4

# FIG_7

3_2

21

2

HT1    HT2    SD    THT    HL

25

22

23

24

SV

2